# EUROPÄISCHE PATENTSCHRIFT

(11) **EP 0 550 794 B1**
(45) Veröffentlichungstag und Bekanntmachung des Hinweises auf die Patenterteilung: **07.05.1997**
(21) Anmeldenummer: 92115147.8
(22) Anmeldetag: 04.09.1992
(51) Int. Cl.: H03M 1/24

(54) **Drehgeber mit Absolutwert-Positionserfassung**
Rotation encoder with absolute value position detection
Codeur de rotation avec détection de valeur absolue de position

(30) Priorität: 30.11.1991 DE 4139570
(43) Veröffentlichungstag der Anmeldung: 14.07.1993
(73) Patentinhaber: IVO IRION & VOSSELER GMBH & CO., D-78022 Villingen-Schwenningen (DE)
(72) Erfinder: Fleig, Manfred, W-7730 VS-Schwenningen (DE); Heddergott, Harry, W-7218 Trossingen 2 (DE)
(74) Vertreter: Patentanwälte Eisele, Otten & Roth

(56) Entgegenhaltungen:
- EP-A- 0 158 781
- EP-A- 0 267 040
- EP-A- 0 331 828

## Beschreibung

Die Erfindung betrifft einen Drehgeber zur Absolutwertspositionserfassung nach dem Oberbegriff des Anspruchs 1.

Drehgeber mit einer Absolutwertpositionserfassung werden üblicherweise mit einer Winkelkodierscheibe und entsprechenden optischen Abtastvorrichtungen (mit z. B. LED, Photodioden etc.) hergestellt. Mit Hilfe einer solchen Scheibe kann die absolute Winkelposition einer mit dieser Scheibe verbundenen Drehgeberwelle innerhalb eines Winkelintervalls von 0° bis 360° erfaßt werden. Ein Winkelbereich über mehrere Umdrehungen ist mit einer einzigen Scheibe nicht meßbar, da sich ihre Kodierung nach Durchlaufen einer Umdrehung naturgemäß wiederholt.

Drehgeber mit einer absoluten Positionswerterfassung über mehrere Umdrehungen hinweg, sogenannte Multiturndrehgeber, sind infolge dessen in verschiedenen Ausführungsformen bekannt geworden.

So wurden beispielsweise mehrere Winkelkodierscheiben über ein Untersetzungsgetriebe miteinander verbunden zum Einsatz gebracht. Das Untersetzungsgetriebe bewirkt, daß die jeweils nachgeschaltete Winkelkodierscheibe bei einer vollständigen Umdrehung der vorgeschalteten Winkelkodierscheibe um eine, ihrem Auflösungsvermögen entsprechende Einheit gedreht wird. Die Funktionsweise eines solchen Multiturngebers ist mit einer herkömmlichen Analoguhr mit verschiedenen Zeigern vergleichbar. Bei einem solchen Drehgeber vervielfacht sich jedoch entsprechend der Anzahl der Kodierscheiben auch die Anzahl der optischen Abtastsysteme. Dieser Umstand sowie der Aufwand, der durch die erforderliche hohe Präzision für das Untersetzungsgetriebe verursacht wird, sind bei dieser Lösung von großem Nachteil.

Desweiteren wurden Multiturndrehgeber entwickelt, die zwar nur mit einer Winkelmeßvorrichtung zur Erfassung eines Winkelbereichs zwischen 0° und 360° versehen sind, jedoch zur Erfassung der vollständig durchlaufenen Umdrehungen eine Zähleinheit aufweisen. Diese Kombination ermöglicht zwar eine Erweiterung des Meßbereichs des Drehgebers auf die maximal von der Zähleinheit erfaßbare Anzahl von Umdrehungen, erfordert jedoch andererseits eine ständige Stromversorgung der Zähleinheit und der Abtastvorrichtung der Winkelkodierscheibe. Bei einer Unterbrechung der Stromversorgung der Zähleinheit geht die darin enthaltene Information verloren. Das Abschalten der Stromversorgung für die Abtastvorrichtung der Winkelkodierscheibe bewirkt außerdem, daß die Zähleinheit neu hinzukommende oder rückgängig gemachte Umdrehungen nicht mehr registrieren kann. Somit geht bei einer Verdrehung der Drehgeberwelle auch in diesem Fall die Information über die absolute Position verloren.

Um diesen Nachteil zu beheben, wurde im folgenden die Stromversorgung des Drehgebers mit Hilfe einer Batterie oder eines Akkumulators gepuffert. So ist beispielsweise mit der europäischen Anmeldung EP 0 466 209 A2 ein Multiturndrehgeber bekannt geworden, der eine Winkelkodierscheibe mit der entsprechenden optischen Nachweisvorrichtung zur Erfassung des Absolutwinkels innerhalb einer Umdrehung aufweist und außerdem einen separaten magnetischen Signalgeber sowie eine Zähleinheit zur Erfassung vollständig durchlaufener Umdrehungen umfaßt. Der genannte Drehgeber wird bei Stromausfall über eine externe Batterie gepuffert.

Eine solche Vorrichtung hat den Nachteil, daß sie ständig wenigstens mit der Hilfsspannungsversorgung verbunden sein muß, um die gespeicherte Information nicht zu verlieren. In vielen Fällen, beispielsweise bei einem Einsatz eines Multiturndrehgebers in einem Roboter, ist es jedoch wünschenswert, daß der Drehgeber seine Information beim Abklemmen äußerer Zuleitungen nicht verliert und darüberhinaus die Bewegungen der Drehgeberwelle weiterhin erfaßt. Dies ist insbesondere dann notwendig, wenn ein Roboter zu Testzwecken aufgebaut wird, um anschließend für die Lieferung wieder in einzelne Komponenten zerlegt zu werden. In einem solchen Fall sind Multiturndrehgeber wünschenswert, die auch nach oder während der Zerlegung des Roboters die Bewegungen und Stellungen der einzelnen Komponenten erfassen, so daß die Anlage nach deren Wiederzusammensetzen nicht in ihren Einzelteilen neu justiert werden braucht.

Der Erfindung liegt daher die Aufgabe zugrunde, einen preiswerten Multiturndrehgeber vorzuschlagen, der ohne externe Spannungsversorgung seine Information zuverlässig erhält und die absolute Position der Drehgeberwelle über eine Vielzahl von Umdrehungen erfaßt. Die Pufferung im Falle abgehängter externer Spannungsversorgung soll hierbei sehr großzügig, d.h. über einen Zeitraum von mehreren Jahren, sichergestellt werden.

Diese Aufgabe wird durch die kennzeichnenden Merkmale des Anspruchs 1 gelöst.

Demgemäß wird bei einem erfindungsgemäßen Drehgeber wenigstens ein mechanisch schließendes Schaltelement in Verbindung mit einem rotierbaren Betätigungsteil, das fest mit der Geberwelle verbunden ist, eingesetzt. Der Strom, der in geschlossenem Zustand über dieses Schaltelement fließt, wird über eine Reihenschaltung mit einem sehr hochohmigen Widerstands begrenzt. Außerdem wird die Logikschaltung zur Pulsformung und zur Pulsselektion, die aus dem Signal des Schaltelementes bei durchdrehendem Betätigungsteil ein logisches Signal pro Umdrehung der Geberwelle generiert sowie die Zähleinheit mit Hilfe von wenigstens einem integrierten Schaltkreis ebenfalls sehr hochohmig ausgelegt. Aufgrund des auf diese Weise extrem reduzierten Stromverbrauchs kann die Pufferbatterie bzw. der Akkumulator so klein gewählt werden, daß diese ebenso wie die genannten elektronischen Schaltungen in die Drehgebereinheit integrierbar ist. Ein derartiger, mit den genannten Komponenten versehener Drehgeber bildet eine kompakte bauliche Einheit und ist ohne externe Stromversorgung über Jahre hinaus funktionsfähig.

Durch die in den Unteransprüchen genannten Maßnahmen sind vorteilhafte Ausführungen und Weiterentwicklungen der Erfindung möglich.

Eine einfache und robuste Ausführung der Erfindung ist mit einem mechanisch wirkenden Betätigungsteil versehen. Ein solches Betätigungsteil kann als Nocken auf der Geberwelle ausgebildet sein, der zwei Kontaktzungen mit den Umdrehungen der Geberwelle öffnet bzw. schließt.

Für ein berührungslos arbeitendes Betätigungsteil empfiehlt sich die Verwendung eines magnetischen Ringes, der über einen Teil seines Umfanges aus einem permanentmagnetischen und zum anderen Teil aus unmagnetischem Material besteht, wobei das Schaltelement als Reed Schalter ausgebildet ist, der bei einer Umdrehung dieses Ringes jeweils einmal geöffnet oder geschlossen wird.

Durch die Verwendung zweier Schaltelemente, die unter einem Winkel von beispielsweise α = 45° zum Nulldurchgang der Winkelmeßvorrichtung angeordnet sind, sowie zweier entsprechender Logikschaltungen zur Erzeugung von Impulsen und zweier Zähler läßt sich der aktuelle Zählerstand mit dem Nulldurchgang der Winkelmeßvorrichtung synchronisieren. Der Zähler, der mit dem bei der jeweiligen Drehrichtung vor dem Nulldurchgang der Winkelmeßvorrichtung schaltenden Schaltelement gekoppelt ist, beinhaltet zum Zeitpunkt des Nulldurchgangs immer den korrekten Wert. Je nach Drehrichtung muß also am Datenausgang zwischen den beiden Zählern hin- und hergeschaltet werden.

Bei einer Logikschaltung, die sowohl bei der ansteigenden als auch bei der abfallenden Flanke des Schaltsignals einen Impuls generiert, sollte der schließend wirksame Winkelbereich des Betätigungsteils größer als der von den beiden Schaltelementen eingeschlossene Winkel α und α' sein. Bei einem solchen Winkelbereich beispielsweise von 180° kann der Schaltzustand des einen Schaltelementes dazu verwendet werden, um von den dem anderen Schaltelement zugehörigen Impulsen jeweils einen Impuls pro Umdrehung zu unterdrücken. Dadurch erhält man am Ausgang der Logikschaltung zu jedem Schaltelement pro Umdrehung genau ein Signal.

Ein Rechtecksignal läßt sich an einer Flanke eines Schaltzustandes eines Schaltelementes beispielsweise mit Hilfe eines Zeitverzögerungsgliedes und eines logischen Antivalenzgatters erzeugen. Die Zeitverzögerung des Zeitverzögerungsgliedes ergibt dabei genau die Breite des Impulses.

Liegt auf diese Weise nur noch an jeder zweiten Flanke des ursprünglichen Schaltsignals ein logischer Impuls hinter der Logikschaltung vor, so beinhaltet die Tatsache, ob es sich um eine ansteigende oder abfallende Flanke handelt, die notwendige Information über die Drehrichtung.

Die oben angeführte Unterdrückung jedes zweiten, auf das eine Schaltelement zurückführenden Impulses mit Hilfe des Signals des anderen Schaltelements kann wiederum mit einem Logikgatter durchgeführt werden.

Das Hin- und Herschalten zwischen den beiden Zählern geschieht vorzugsweise mit Hilfe eines Multiplexers, der den jeweils aktuellen Zählerinhalt im Takt mit dem höchstwertigen Bit der von der Winkelmeßvorrichtung abgelesenen binären Zahl auf den Datenausgang des Drehgebers durchschaltet. Auf diese Weise wird der am Ausgang anliegende Datenwert des Drehgebers mit dem Nulldurchgang der Winkelmeßvorrichtung während der Rotation der Geberwelle synchronisiert.

Besonders vorteilhaft ist die Implementierung der genannten Logikschaltungen zur Pulsformung und Pulsselektion auf einen sogenannten anwendungsspezifischen integrierten Schaltkreis (ASIC). Hierdurch kann die Schaltung besonders hochohmig ausgelegt werden und gleichzeitig äußerst platzsparend ausgebildet sein. Dies ist insbesondere im Hinblick darauf, daß alle genannte Komponenten vollständig in die Drehgebereinheit integriert werden, von großem Vorteil.

Die Winkelmeßvorrichtung kann eine optische, eine kapazitive oder eine induktive Abtastvorrichtung umfassen. Ein an die Abtastvorrichtung angepaßtes Winkelkodierteil, das mit der Drehgeberwelle rotiert, beispielsweise eine Winkelkodierscheibe für eine optische Abtastvorrichtung, ist hierbei vorzusehen.

Ein Ausführungsbeispiel der Erfindung ist in der Zeichnung dargestellt und wird in der nachfolgenden Beschreibung näher erläutert.

Es zeigen
- Fig. 1: einen Längsschnitt durch einen erfindungsgemäßen Drehgeber,
- Fig. 2: eine schematische Draufsicht auf einen magnetischen Signalgeber, wie er in einem erfindungsgemäßen Drehgeber Verwendung findet,
- Fig. 3: ein Blockdiagramm der Signalverarbeitung,
- Fig. 4: ein Schaltbild der signalverarbeitenden elektronischen Schaltung und
- Fig. 5: ein Diagramm zur Darstellung des Zeitverlaufs verschiedener Spannungspegel in der Schaltung nach Fig. 4 während der Betätigung des Drehgebers.

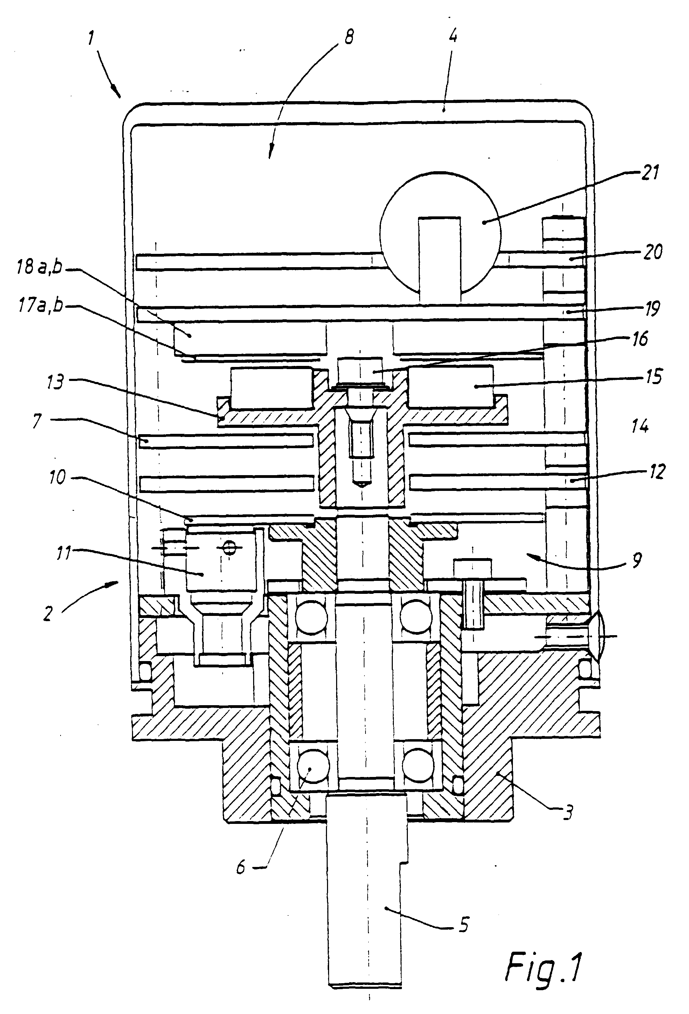

Fig. 1 zeigt einen Drehgeber 1 mit einem Drehgebergehäuse 2, das aus einem Stator 3 und einem Gehäusedeckel 4 besteht. Von unten durchsetzt eine Geberwelle 5, die durch Kugellager 6 drehbar gelagert ist, den Stator 3. Das Innere des Gehäuses 2 wird durch eine Abschirmplatte 7 in einen oberen 8 und einen unteren Teil 9 aufgeteilt. Im unteren Teil 9 befinden sich die Komponenten des Drehgebers 1, die zur Erfassung der Winkelposition innerhalb einer Umdrehung (Singleturngeber) vorgesehen sind. Im einzelnen sind dies eine Winkelkodierscheibe 10, die von einer optischen Sendeeinheit 11 von unten her beleuchtet wird. Oberhalb der Winkelkodierscheibe 10 befindet sich eine Empfängerleiterplatte 12, die nicht dargestellte optische Sensoren sowie eine Empfängerschaltung aufweist.

Im oberen Teil 8 des Drehgebers 1 befindet sich ein Magnethalter 13, der auf die Geberwelle 5 aufgesteckt ist. Der über die Geberwelle 5 gesteckte Teil 14 des Magnethalters 13 durchsetzt die Abschirmplatte und ragt in den unteren Teil 9 des Drehgebers 1 hinein. Auf dem Magnethalter 13 ist an der Oberseite ein magnetischer Ring 15 befestigt. Eine Schraube 16 fixiert den Magnethalter 13 auf der Geberwelle 5. Oberhalb des magnetischen Ringes befinden sich zwei Reedschalter 17a, b innerhalb ihrer Abschirmkappen 18a, 18b. Die beiden Reedschalter 17a, 17b sind auf einer Leiterplatte 19 befestigt, auf der die nicht eingezeichneten Schaltungen zur Signalformung und Selektion sowie die Zähler aufgebaut sind. An die Leiterplatte 19 schließt sich nach oben hin eine Leiterplatte 20 mit einer Gleichspannungsquelle sowie eine Batterie 21 an.

Die Komponenten im unteren Teil 9 des Drehgebers arbeiten in der von herkömmlichen Winkelturndrehgeber bekannten Weise zur Winkelauflösung innerhalb einer Umdrehung der Geberwelle 5.

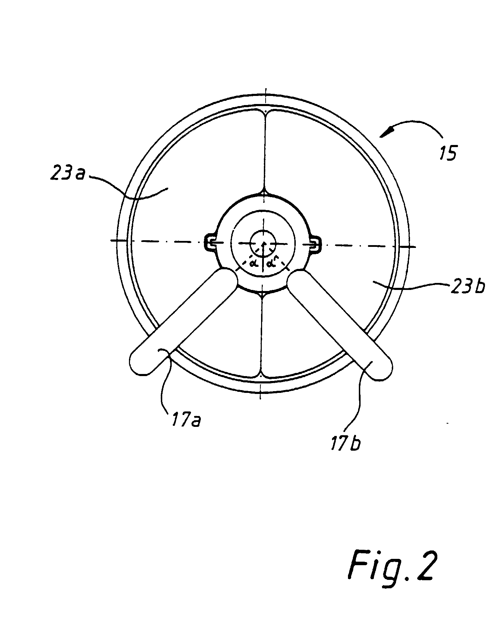

Die Anordnung der beiden Reedschalter 17a, 17b im oberen Teil 8 des Drehgebers ist in der schematischen Draufsicht von Fig. 2 dargestellt. Sie stehen unter einem Winkel von α bzw. α'≈45° zur Linie 22, die dem Nulldurchgang der Winkelkodierscheibe 10 entspricht. Der magnetische Ring 15 ist aus einem magnetischen 23a und einem nicht magnetischen Teil 23b zusammengesetzt, so daß die Reed-Schalter dann geöffnet sind, wenn sich der magnetische Teil 23a des magnetischen Ringes unter ihnen befindet, und im anderen Fall geschlossen sind.

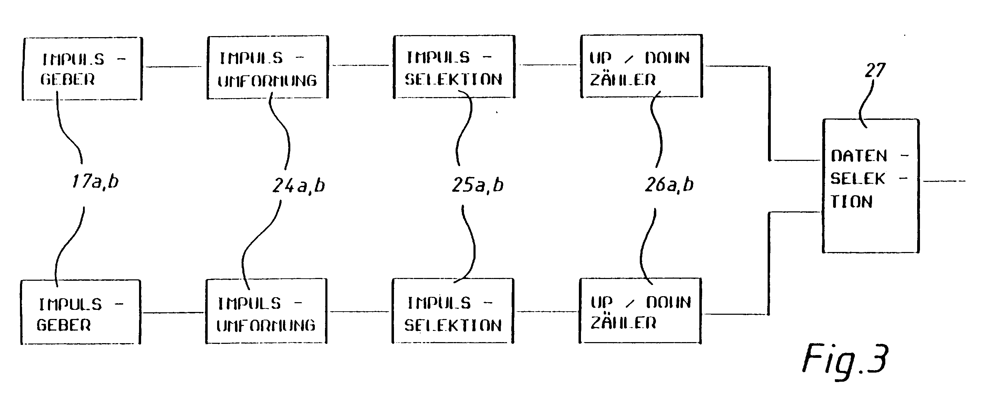

Die so durch die verschiedenen Schaltzustände der Reed-Schalter 17a, 17b erzeugten Signale werden gemäß dem in Fig. 3 dargestellten Blockschaltbild weiter verarbeitet. Die von den Reed-Schaltern als Impulsgeber 17a, 17b erzeugten Signale gelangen in eine elektronische Schaltung zur Impulsformung 24, die aus jeder Flanke ihres Eingangssignals einen logischen Rechteckimpuls bildet. Im Anschluß daran werden diese Rechteckimpulse in einer Schaltung 25 zur Impulsselektion dergestalt selektiert, daß am Ausgang dieser Schaltung jeweils ein Rechteckimpuls pro Umdrehung der Geberwelle 5 anliegt. Diese so bearbeitenden Impulse werden schließlich in zwei Zählern gezählt und gespeichert. Da die beiden Reed-Schalter unter einem Winkel α bzw.α' zum Nulldurchgang 22 stehen, läuft also bei einer bestimmten Drehrichtung der aktuelle Zählerstand des einen Zählers dem tatsächlichen Wert voraus, während der Zählerstand des anderen Zählers hinterherläuft. Über eine Schaltung zur Datenselektion 27 wird der Zähler mit dem jeweils richtigen Datenbestand ausgewählt und synchron mit dem Nulldurchgang der Winkelkodierscheibe 10 zu deren Ausgang durchgeschaltet.

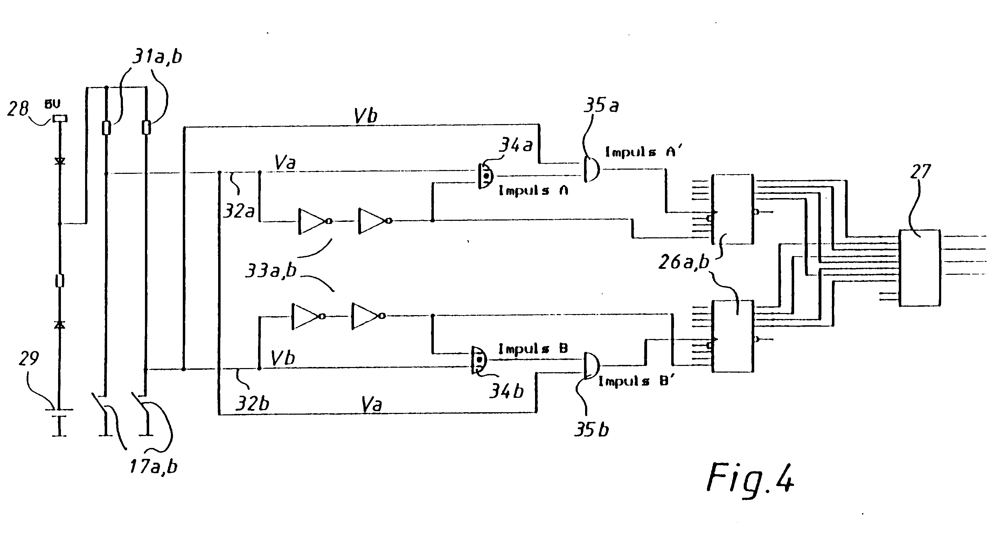

In Fig. 4 ist eine mögliche Schaltung für eine Signalverarbeitung nach Fig. 3 dargestellt. Eine externe Spannungsversorgung 28 sowie eine Lithiumbatterie 29 liefern je nach Bedarf die Betriebsspannung für die folgende Schaltung. Die beiden Reed-Schalter 17a, 17b schalten je nach Schaltzustand die beiden Stromleitungen 30a, 30b über zwei sehr hochohmige und damit strombegrenzende Widerstände 31a, 31b gegen die Schaltungsmasse. Dadurch variieren je nach Schaltzustand die Spannungen Va, Vb, die in den Signalleitungen 32a, 32b anliegen. Durch die Verwendung eines Zeitverzögerungsgliedes 33a, 33b und eines Anitvalenzgatters 34a, 34b wird ein Rechteckimpuls A bzw. B am Ausgang der Antivalenzgatter 34a, 34b erzeugt. Mit Hilfe von Und-Gattern 34a, 34b sowie den jeweils dem anderen Datenkanal zuzuordnenen Spannungen Va, Vb der Signalleitungen 32a, 32b wird genau ein Rechteckimpuls A' bzw. B' pro Umdrehung der Geberwelle selektiert. In den Zählern 26a, 26b werden die Signale gezählt und gespeichert. Ein Multiplexer 36 selektiert den jeweils aktuellen Datenkanal und schaltet dessen Zählerstand auf seinen Ausgang durch.

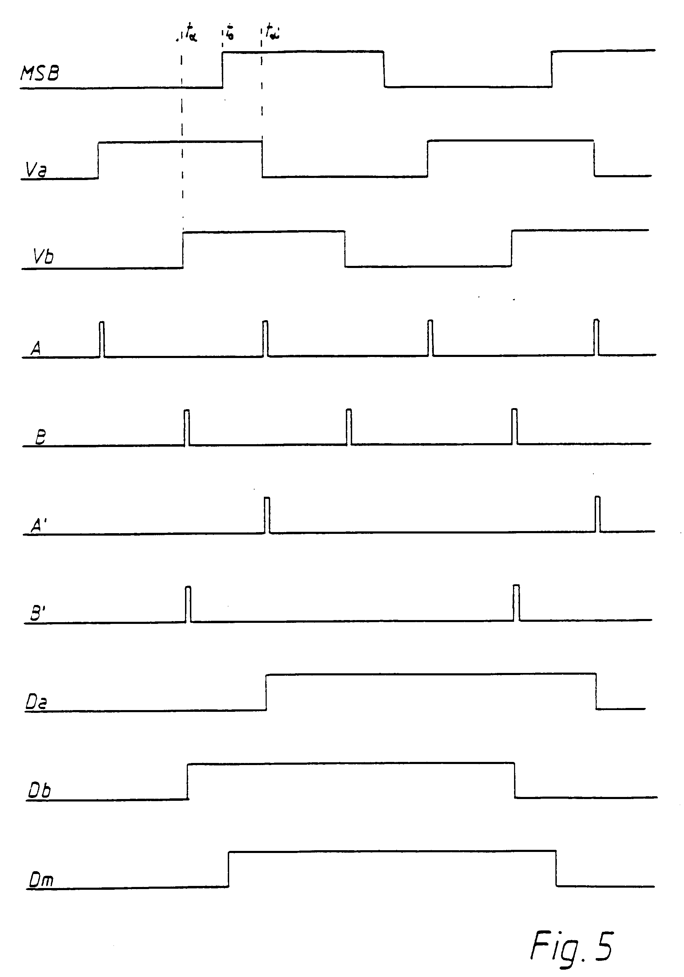

Der Zeitverlauf der verschiedenen Signale während des Drehens der Geberwelle ist in Fig. 5 dargestellt. Das oberste Diagramm stellt das höchstwertige Bit MSB am Ausgang des im unteren Teil 9 des Drehgebers 1 befindlichen Singleturndrehgebers. Dieses Bit wird genau mit dem Nulldurchgang der Geberwelle zum Zeitpunkt tₒ gesetzt und bei 180° auf "Low" geschaltet. Die beiden nach unten anschließenden Diagramme spiegeln den Spannungsverlauf Va, Vb in den Signalleitungen 32a, 32b wieder. Der Signalverlauf entspricht dem des höchstwertigen Bit MSB, ist jedoch jeweils um eine Zeit tα, tα', in der sich die Geberwelle 5 um die Winkel α bzw. α' dreht, versetzt. Die beiden folgenden Diagramme stellen die Impulse A, B am Ausgang der Antivalenzgatter 34a, 34b dar. Die Breite der Rechteckimpulse A, B entspricht genau der Zeitverzögerung der Zeitverzögerungsglieder 33a, 33b. Die beiden darunterliegenden Diagramme machen deutlich, daß am Ausgang der Und-Gatter 35 nur noch jedes zweite Rechtecksignal A', B' selektiert werden. Demzufolge werden mit dem Eingang dieser Rechtecksignale A', B' die untersten Datenbits, Da, Db der beiden Zähler 26a, 26b geschaltet. Das unterste Diagramm zeigt anhand des niedrigsten Datenbits Da, Db, wie der, entsprechend der Drehrichtung aktuelle Zählerstand, in diesem Fall Db synchron mit dem höchstwertigen Bit der Winkelkodierscheibe MSB am Ausgang des Multiplexers 27 als Datenbit Dm ausgegeben wird.

Ein erfindungsgemäßer Drehgeber kommt durch die beschriebenen Maßnahmen mit Pufferströmen aus, die kleiner als 10 µA sind. Bei der Verwendung einer kleinen Lithiumbatterie mit 0,95 Ah ergibt sich somit eine gesicherte Funktion bei externem Stromausfall von ca. 10 Jahren.

## Patentansprüche

1. Drehgeber (1) zur Absolutwertpositionserfassung, mit einem Stator (3) und einer drehbar im Stator gelagerten Geberwelle (5), wobei der Drehgeber (1) eine Winkelmeßvorrichtung zur Erfassung der genauen Position der Geberwelle (5) während einer vollständigen Umdrehung in einem Winkelintervall von 0° - 360° und eine Ausgabeeinheit zur Ausgabe der erfaßten Position der Geberwelle als Winkelangabe auf einem Datenausgang aufweist, wobei die Winkelmeßvorrichtung und die Ausgabeeinheit von einer externen Stromversorgung gespeist werden und wobei der Drehgeber darüberhinaus eine Vorrichtung zur Erfassung der Anzahl der vollständig durchlaufenen Umdrehungen mit einem drehfest angeordneten ersten Teil (17) und einem an der Geberwelle (5) befestigten, mit dieser rotierenden zweiten Teil (15) aufweist, und der Drehgeber (1) mit einer Logikschaltung zur Formung und Selektion (24, 25) eines logischen Impulses aus dem Ausgangssignal der Vorrichtung zur Erfassung der Umdrehungen der Geberwelle (5) sowie zur Erfassung der Drehrichtung versehen ist und eine drehrichtungsabhängige Zähleinheit (26) aufweist, die die so generierten logischen Impulse je nach Drehrichtung auf den jeweiligen Zählerstand summiert bzw. davon subtrahiert und deren aktueller Zählerstand auf dem Datenausgang auslesbar ist, und wobei eine Batterie (21) oder ein Akkumulator zur Aufrechterhaltung der Stromversorgung für die Vorrichtung zur Erfassung ganzer Umdrehungen, die Logikschaltung (24, 25) und die Zähleinheit (26) bei einer Unterbrechung der ansonsten zugeführten externen Stromversorgung vorgesehen ist, dadurch gekennzeichnet, daß die Vorrichtung zur Erfassung ganzer Umdrehungen ein mechanisch schließendes Schaltelement und ein mit der Geberwelle (5) verbundenes, rotierbares Betätigungsteil für das Schaltelement aufweist, daß zur Reduzierung der notwendigen Größe der Batterie (21) oder des Akkumulators zur Pufferung des Drehgebers (1) bei Ausfall der externen Stromversorgung (28) eine Schaltung (24) vorhanden ist, die einen wenigstens bei geschlossenem Schaltelement (17) sehr hochohmigen Widerstand (31) in Reihe mit diesem aufweist, so daß der Strom in dieser Schaltung begrenzt ist, daß die Logikschaltung (24, 25) zur Pulsformung und zur Selektion mit wenigstens einem integrierten Schaltkreises ausgeführt und ebenso wie die Zähleinheit (26) hochohmig ausgelegt ist und daß die Logikschaltung (24, 25), die Zähleinheit (26), das Schaltelement (15, 17) sowie die Pufferbatterie (21) bzw. Akkumulator vollständig in die Drehgebereinheit (2) integriert sind, so daß der Drehgeber (1) mit den genannten Komponenten eine kompakte bauliche Einheit bildet.

2. Drehgeber nach einem der vorhergehenden Ansprüche dadurch gekennzeichnet, daß ein mechanisch wirkendes Betätigungsteil zur Betätigung des mechanisch schließenden Schaltelementes vorgesehen ist.

3. Drehgeber nach Anspruch 1 oder 2, dadurch gekennzeichnet, daß auf der Geberwelle (5) als Betätigungsteil ein magnetischer Ring (15) montiert ist, der aus einem magnetisch wirksamen Teil (23a) und einem magnetisch nicht wirksamen Bereich (23b) besteht, und daß das mechanisch schließende Schaltelement ein Reedkontakt (17) ist, der beim Rotieren des magnetischen Rings (15), abhängig davon, ob ein magnetisch wirksamer (23a) oder nicht wirksamer (23b) Teil des magnetischen Rings (15) in seiner Nähe durchläuft alternierend geöffnet bzw. geschlossen ist.

4. Drehgeber nach einem der vorhergehenden Ansprüche, dadurch gekennzeichnet, daß der magnetische Ring (15) aus einem magnetischen Teil (23a) und einem nicht magnetischen Teil (23b) zusammengesetzt ist.

5. Drehgeber nach einem der vorhergehenden Ansprüche, dadurch gekennzeichnet, daß er zwei Schaltelemente (17a, 17b), die unter einem Winkel von 45° zum Nulldurchgang (22) der Geberwelle (5) angeordnet sind, zwei Logikschaltungen (24a, 24b, 25a, 25b) zur Erzeugung von Impulsen und zwei Zähler (26a, 26b) umfaßt und daß der schließend wirksame Teil (23a) und der nicht schließend wirksame Teil (23b) des Betätigungsteils (15) so ausgebildet sind, daß die Schaltelemente (17) alle 180° während der Rotation der Geberwelle (5) geschaltet werden.

6. Drehgeber nach einem der vorhergehenden Ansprüche, dadurch gekennzeichnet, daß aus den verschiedenen Schaltzuständen (Va, Vb) der Schaltelemente (17a, 17b) mittels eines Zeitverzögerungsgliedes (33) und eines logischen Gatters (34) ein Impuls erzeugt wird, daß die Richtung der Flanke des vom Schaltelement (17a, 17b) ausgehenden Signals (Va, Vb) zum Schalten des Zählmodus des Zählers zwischen Addition oder Subtraktion verwendbar ist und daß die Signalleitung (32a, 32b) des einen Schaltelementes (17a, 17b) so mit einem Logikgatter (35a, 35b) und der Signalleitung (32a, 32b) des anderen Schaltelementes (17a, 17b) geschaltet ist, daß jeder zweite Impuls unterdrückt wird und pro vollständiger Umdrehung der Geberwelle (5) nur ein Impuls erzeugt wird.

7. Drehgeber nach einem der vorhergehenden Ansprüche, dadurch gekennzeichnet, daß ein Multiplexer (27) vorhanden ist, der je nach Drehrichtung den Zählerinhalt jeweils eines Zählers (26a, 26b) des Drehgebers (1) im Takt mit dem höchstwertigen Bit (MSB) des von der Winkelmeßvorrichtung (10) abgelesenen Codes so auf den Datenausgang des Drehgebers (1) durchschaltet, daß der am Ausgang anliegende Datenwert des Drehgebers (1) mit dem Nulldurchgang (22) des Winkelkodierteils (10) der Winkelmeßvorrichtung auf der Geberwelle (5) während deren Rotation synchronisierbar ist.

8. Drehgeber nach einem der vorhergehenden Ansprüchen dadurch gekennzeichnet, daß die Winkelmeßvorrichtung mit einer optischen Abtastvorrichtung und einem entsprechenden Winkelkodierteil versehen ist.

9. Drehgeber nach einem der vorhergehenden Ansprüchen dadurch gekennzeichnet, daß die Winkelmeßvorrichtung mit einer kapazitiven Abtastvorrichtung und einem entsprechenden Winkelkodierteil versehen ist.

10. Drehgeber nach einem der vorhergehenden Ansprüchen dadurch gekennzeichnet, daß die Winkelmeßvorrichtung mit einer induktiven Abtastvorrichtung und einem entsprechenden Winkelkodierteil versehen ist.

## Claims

1. Rotation encoder (1) for absolute value position detection, with a stator (3) and an encoder shaft (5) mounted to rotate in the stator, the rotation encoder (1) comprising an angle-measuring device for detecting the exact position of the encoder shaft (5) during a complete revolution in an angular interval of 0° to 360° and an output unit for issuing the detected position of the encoder shaft as angular information at a data output, the angle-measuring device and the output unit being supplied by an external power supply and the rotation encoder in addition comprising a device for detecting the number of completed revolutions with a first part (17) arranged in a non-rotary manner and a second part (15) attached to the encoder shaft (5) and rotating with the latter, and the rotation encoder (1) being provided with a logic circuit for the forming and selection (24, 25) of a logic pulse from the output signal of the device for detecting the revolutions of the encoder shaft (5) as well as for detecting the direction of rotation and comprising a counting unit (26) dependent on the direction of rotation, which adds the logic pulses generated in this way according to the direction of rotation to the respective counter reading or subtracts them therefrom and whereof the current counter reading can be read-off at the data output, and a battery (21) or a storage battery being provided for maintaining the power supply for the device for detecting complete revolutions, the logic circuit (24, 25) and the counting unit (26) in the case of an interruption of the otherwise external power supply, characterised in that the device for detecting complete revolutions comprises a mechanically closing switching element and a rotatable actuating part for the switching element, connected to the encoder shaft (5), that for reducing the necessary size of the battery (21) or of the storage battery for buffering the rotation encoder (1) in the case of a failure of the external power supply (28), a circuit (24) is provided, which comprises a resistor (31), which is very highly resistive at least when the switching element (17) is closed, in series with the latter, so that the current in this circuit is limited, that the logic circuit (24, 25) for the formation of pulses and for selection is constructed with at least one integrated switching circuit and in the same way as the counting unit (26) is designed to be highly resistive and that the logic circuit (24, 25), the counting unit (26), the switching element (15, 17) as well as the buffer battery (21) or storage battery are integrated completely in the rotation encoder unit (2), so that the rotation encoder (1) forms a compact structural unit with the said components.

2. Rotation encoder according to one of the preceding Claims, characterised in that a mechanically operating actuating part is provided for actuating the mechanically closing switching element.

3. Rotation encoder according to Claim 1 or 2, characterised in that mounted on the encoder shaft (5) as the actuating part is a magnetic ring (15), which consists of a magnetically active part (23a) and a magnetically non-active region (23b), and that the mechanically closing switching element is a Reed contact (17), which is alternately opened or closed upon rotation of the magnetic ring (15) irrespective of whether a magnetically active (23a) or non-active (23b) part of the magnetic ring (15) passes in its vicinity.

4. Rotation encoder according to one of the preceding Claims, characterised in that the magnetic ring (15) is composed of a magnetic part (23a) and a non-magnetic part (23b).

5. Rotation encoder according to one of the preceding Claims, characterised in that it comprises two switching elements (17a, 17b), which are arranged at an angle of α = 45° with respect to the zero passage (22) of the encoder shaft (5), two logic circuits (24a, 24b, 25a, 25b) for producing pulses and two counters (26a, 26b) and that the part (23a) having a closing action and the part (23b) having a non-closing action of the actuating part (15) are constructed so that the switching elements (17) are actuated every 180° during the rotation of the encoder shaft (5).

6. Rotation encoder according to one of the preceding Claims, characterised in that a pulse is produced from the different switching states (Va, Vb) of the switching elements (17a, 17b) by means of a time delay member (33) and a logic gate (34), that the direction of the edge of the signal (Va, Vb) emanating from the switching element (17a, 17b) can be used for switching the counting mode of the counter between addition or subtraction and that the signal lead (32a, 32b) of one switching element (17a, 17b) is connected to a logic gate (35a, 35b) and the signal lead (32a, 32b) of the other switching element (17a, 17b) is connected so that every other pulse is suppressed and only one pulse is produced per complete revolution of the encoder shaft (5).

7. Rotation encoder according to one of the preceding Claims, characterised in that a multiplexer (27) is provided, which according to the direction of rotation connects through the counter contents respectively of one counter (26a, 26b) of the rotation encoder (1) in synchronism with the highest value bit (MSB) of the code read by the angle-measuring device (10) at the data output of the rotation encoder (1) so that the data value of the rotation encoder (1) present at the output can be synchronised with the zero passage (22) of the angle-coding part (10) of the angle-measuring device on the encoder shaft (5) during its rotation.

8. Rotation encoder according to one of the preceding Claims, characterised in that the angle-measuring device is provided with an optical scanning device and a corresponding angle-coding part.

9. Rotation encoder according to one of the preceding Claims, characterised in that the angle-measuring device is provided with a capacitive scanning device and a corresponding angle-coding part.

10. Rotation encoder according to one of the preceding Claims, characterised in that the angle-measuring device is provided with an inductive scanning device and a corresponding angle-coding part.

## Revendications

1. Encodeur (1) pour la détection de position de valeur absolue, comportant un stator (3) et un arbre d'encodeur (5) monté de façon rotative dans le stator, l'encodeur (1) présentant un dispositif de mesure angulaire pour détecter la position précise de l'arbre d'encodeur (5) pendant un tour complet dans un intervalle angulaire de 0°-360° et une unité de sortie pour sortir la position détectée de l'arbre d'encodeur comme donnée angulaire sur une sortie de données, le dispositif de mesure angulaire et l'unité de sortie étant alimentés par une alimentation en courant externe, et l'encodeur présentant de plus un dispositif pour détecter le nombre des tours complètement parcourus présentant une première partie (17) agencée de façon résistant à la torsion et une seconde partie (15) fixée à l'arbre d'encodeur (5) et tournant avec celui-ci, et l'encodeur (1) étant muni d'un circuit logique pour former et sélectionner (24,25) une impulsion logique à partir du signal de sortie du dispositif pour détecter les tours de l'arbre d'encodeur (5) ainsi que pour détecter le sens de rotation et présentant une unité de comptage (26) dépendant du sens de rotation, qui additionne les impulsions logiques ainsi engendrées selon le sens de rotation à l'état du compteur respectif ou l'en soustrait et dont l'état du compteur actuel peut être lu sur la sortie de données, et une batterie (21) ou un accumulateur étant prévu pour maintenir l'alimentation en courant pour le dispositif pour détecter des tours entiers, le circuit logique (24,25), et l'unité de comptage (26) lors d'une interruption de l'alimentation en courant externe sinon fournie,
caractérisé en ce que le dispositif pour détecter des tours entiers présente un élément de commutation se fermant mécaniquement et une partie d'actionnement rotative liée à l'arbre d'encodeur (5) pour l'élément de commutation, en ce que, pour réduire la taille nécessaire de la batterie (21) ou de l'accumulateur pour tamponner l'encodeur (1) lors d'une panne de l'alimentation en courant externe (28), il existe un circuit (24) qui présente une résistance (31) à très haute impédance, au moins lorsque l'élément de commutation (17) est fermé, en série avec celui-ci, de sorte que le courant dans ce circuit est limité, en ce que le circuit logique (24,25) pour former les impulsions et pour sélectionner est réalisé avec au moins un circuit de commutation intégré et, de même que l'unité de comptage (26), présente une haute impédance, et en ce que le circuit logique (24, 25), l'unité de comptage (26), l'élément de commutation (15,17), ainsi que la batterie tampon (21) ou l'accumulateur sont intégrés totalement dans l'unité d'encodeur (2), de sorte que l'encodeur (1) forme, avec les composants cités, une unité constructive compacte.

2. Encodeur selon une des revendications précédentes,
caractérisé en ce qu'une partie d'actionnement agissant de façon mécanique est prévue pour l'actionnement de l'élément de commutation se fermant mécaniquement.

3. Encodeur selon la revendication 1 ou 2,
caractérisé en ce que, sur l'arbre d'encodeur (5), comme pièce d'actionnement, il est monté une bague magnétique (15) qui est constituée d'une partie agissant magnétiquement (23a) et d'une zone (23b) qui n'agit pas magnétiquement, et en ce que l'élément de commutation se fermant mécaniquement est un contact Reed (17), qui, lors de la rotation de la bague magnétique (15), de façon dépendant du fait qu'une partie agissant de façon magnétique (23a) ou une partie non agissante (23b) de la bague magnétique (15) se trouve à sa proximité, est alternativement ouvert ou fermé.

4. Encodeur selon une des revendications précédentes,
caractérisé en ce que la bague magnétique (15) est constituée d'une partie magnétique (23a) et d'une partie non magnétique (23b).

5. Encodeur selon une des revendications précédentes,
caractérisé en ce qu'il comporte deux éléments de commutation (17a,17b), qui sont agencés sous un angle de 45° par rapport au passage par zéro (22) de l'arbre d'encodeur (5), deux circuits logiques (24a,24b,25a,25b) pour engendrer des impulsions, et deux compteurs (26a,26b), et en ce que la partie agissant en fermant (23a) et la partie n'agissant pas en fermant (23b) de la pièce d'actionnement (15) sont réalisées de sorte que les éléments de commutation (17) sont commutés tous les 180° pendant la rotation de l'arbre d'encodeur (5).

6. Encodeur selon une des revendications précédentes,
caractérisé en ce que, à partir des différents états de commutation (Va,Vb) des éléments de commutation (17a,17b), il est engendré, au moyen d'un organe de temporisation (33) et d'une porte logique (34), une impulsion, en ce que le sens du flanc du signal (Va,Vb) sortant de l'élément de commutation (17a,17b) peut être utilisé pour commuter le mode de comptage du compteur entre l'addition et la soustraction, et en ce que la liaison de signaux (32a,32b) d'un élément de commutation (17a,17b) est commutée par une porte logique (35a,35b) et la liaison de signaux (32a,32b) de l'autre élément logique (17a,17b), de sorte que chaque seconde impulsion est supprimée et, pour un tour complet de l'arbre d'encodeur (5), uniquement une impulsion est engendrée.

7. Encodeur selon une des revendications précédentes,
caractérisé en ce qu'un multiplexeur (27) est prévu qui, selon le sens de rotation, connecte le contenu d'à chaque fois un compteur (26a,26b) de l'encodeur (1) en synchronisme avec le bit de valeur maximale (MSB) du code lu par le dispositif de mesure angulaire (10), sur la sortie de données de l'encodeur (1), de sorte que la valeur de donnée, se trouvant à la sortie, de l'encodeur (1) peut être synchronisée avec le passage par zéro (22) de la partie de codage angulaire (10) du dispositif de mesure angulaire sur l'arbre d'encodeur (5) pendant sa rotation.

8. Encodeur selon une des revendications précédentes,
caractérisé en ce que le dispositif de mesure angulaire est muni d'un dispositif de balayage optique et d'une partie de codage angulaire correspondante.

9. Encodeur selon une des revendications précédentes,
caractérisé en ce que le dispositif de mesure angulaire est muni d'un dispositif de balayage capacitif et d'une partie de codage angulaire correspondante.

10. Encodeur selon une des revendications précédentes,
caractérisé en ce que le dispositif de mesure angulaire est muni d'un dispositif de balayage inductif et d'une partie de codage angulaire correspondante.
